# Europäisches Patentamt

(19) **European Patent Office**

**Office européen des brevets**

(11) Publication number: **0 172 193**
**B1**

(12) # EUROPEAN PATENT SPECIFICATION

(45) Date of publication of the patent specification:
**19.04.89**

(51) Int. Cl.⁴: **H 01 L 29/68**

(21) Application number: **85900935.9**

(22) Date of filling: **04.02.85**

(86) International application number:
**PCT/US 85/00173**

(87) International publication number:
**WO 85/03599 (15.08.85 Gazette 85/18)**

(54) **PROGRAMMABLE READ-ONLY MEMORY CELL AND METHOD OF FABRICATION.**

(30) Priority: **09.02.84 US 578333**

(43) Date of publication of application:
**26.02.86 Bulletin 86/9**

(45) Publication of the grant of the patent:
**19.04.89 Bulletin 89/16**

(84) Designated Contracting States:
**DE GB NL**

(56) References cited:
**FR-A-2 291 609**
**US-A-4 015 282**
**US-A-4 146 902**

**I. Ruge: "Halbleiter-Technologie", Springer-Verlag, Berlin 1975, pp. 265-268**

**The file contains technical information submitted after the application was filed and not included in this specification**

(73) Proprietor: **NCR Corporation, World Headquarters, Dayton, Ohio 45479 (US)**

(72) Inventor: **ELLSWORTH, Daniel, Lloyd, 2723 Alan Street, Fort Collins, CO 80524 (US)**
Inventor: **SULLIVAN, Paul, Andrew, 1136 Oakmont Court, Fort Collins, CO 80525 (US)**

(74) Representative: **Robinson, Robert George, International Patent Department NCR Limited 206 Marylebone Road, London NW1 6LY (GB)**

LIBER, STOCKHOLM 1989

## Description

## Technical Field

This invention relates to electrically programmable read-only memory cells. The invention also relates to a process for fabricating electrically programmable read-only memory cells.

## Background Art

A programmable read-only memory (PROM) is known from U.S. Patent Specification No. 4 403 399, which discloses a vertical diode/bipolar transistor structure. This device is programmed by creating an extremely high power density region in a thin epitaxial layer to induce migration of aluminum particles, therefore shorting the blocking diode junction. The bipolar devices in the array provide some current gain but their effectiveness is degraded by the high programming currents required to short the blocking diode junction since the bipolar transistor gain is low at such high current. Greater current could be obtained from the bipolar transistor by increasing the emitter area; however, because the size of the blocking diode is determined by the emitter size a larger diode requires a proportionately larger programming current. For this configuration, most of the programming current must be supplied as base current to the bipolar transistors from the peripheral circuitry. Therefore, this device is best built in a bipolar process with bipolar peripheral circuitry and two levels of low resistivity interconnect.

A PROM is also known from an article by Tanimoto et al., "A Novel MOS PROM Using Highly Resistive Polysilicon Resistor", IEEE Transactions on Electron Devices, Vol ED-27, No. 3, pages 517 - 520, March 1980. This PROM utilizes a vertical "anti-fuse" structure and contains only MOS circuitry. By an "anti-fuse" is meant a structure which becomes more conductive as a result of a programming operation, in distinction to a "fuse" which becomes less conductive. The anti-fuse consists of high resistivity polysilicon which undergoes a dramatic decrease in resistivity upon application of sufficient voltage and current. The current required to lower the resistivity of the polysilicon is much lower than required to short the blocking diode in the device described above. The current is lower because a different physical mechanism is employed, i.e. a memory switching phenomenon. This known memory has the advantages of low power consumption, lower cost and reduces process complexity. Since a vertical anti-fuse structure is utilized, the lateral area consumed by each bit is reduced when compared to a lateral fuse. However, an MOS transistor is required at each bit in the array. The MOS transistor used with each cell is an inherently lateral device adjacent to the anti-fuse structure. This known cell therefore has the disadvantage of lowering the density of the PROM, even though the anti-fuse is vertical. In US-A-4 146 902, there is described a similar memory cell, the MOS transistor of which may be replaced by a bipolar transistor. The high resistivity polysilicon region of the anti-fuse structure is connected to the active element via a terminal electrode means, e.g. a heavily doped polysilicon region.

## Disclosure of the Invention

It is an object of the present invention to provide a read-only memory cell having a relatively low power consumption for programming, wherein the aforementioned disadvantage is alleviated.

Therefore, according to the present invention, there is provided an electrically programmable read-only memory cell, including a semiconductor substrate having a first conductivity type, a base region and a base contact region having a second conductivity type provided in said substrate, an emitter region having said first conductivity type provided in said base region, a dielectric layer provided over said base region and said base contact region and having openings formed therethrough, an anti-fuse structure including a region of undoped polysilicon in dirrect contact with said emitter region and a conductive layer of said first conductivity type formed on said region of undoped polysilicon, said anti-fuse structure having a defined periphery extending over a portion of said dielectric layer, and conductive connections provided for said conductive layer and said base contact region.

Further advantages of a memory cell according to the invention are high reliability and low manufacturing cost. High reliability is aided since a passivation layer covering the device can be provided without apertures to permit the expulsion of blown fuse material.

According to another aspect of the invention, there is provided a process of fabricating an electrically programmable read-only memory cell, including the steps of: providing a semiconductor wafer; forming in a base region of said semiconductor wafer an exposed emitter region of a first conductivity type and an associated adjacent base contact region for a bipolar transistor, said base and base contact regions having a second conductivity type; providing a region of undoped polysilicon on said emitter region; forming a conductive layer having said first conductivity type on said region of undoped polysilicon; and providing an ohmic connection to said conductive layer, thereby forming a programmable antifuse structure directly connected to the emitter region of said bipolar transistor.

In a preferred embodiment of the invention, a PROM cell is formed on a common chip with CMOS devices, the process according to the invention thus being seen to possess the advantage of compatability with CMOS processing technology. Thus, the preferred embodiment enables the provision of a PROM with a high density, merged, vertical fuse/bipolar transistor which can be fabricated by utilizing CMOS process technology to achieve a low cost PROM with low power consumption and high reliability.

## Brief Description of the Drawings

Two embodiments of the invention will now be described by way of example with reference to the accompanying drawings, in which:

Figs. 1 - 8 are cross-sectional representations of an integrated circuit element showing the steps utilized in fabricating a single memory cell in an array of similar memory cells in accordance with a first embodiment of the invention; and

Fig. 9 is a cross-sectional representation illustrative of a second embodiment of the invention.

## Best Mode for Carrying Out the Invention

It should be understood that in the preferred embodiment a PROM is fabricated in a common structure with polysilicon gate CMOS devices (not shown). Thus, a silicon wafer is processed to provide CMOS devices and vertical polysilicon anti-fuse structures which are merged with self-aligned emitters of respective bipolar transistors. The silicon wafers of one conductivity type, e.g. n-type, are provided with wells of the opposite conductivity type, e.g. p-wells, and vertical NPN devices fabricated in n-type substrate regions. The PROM includes an array of cells, each having an emitter follower and a pad of semiconductor material which serves as an anti-fuse and constitutes the programmable element. For purposes of clarity, only a single cell is shown in the figures.

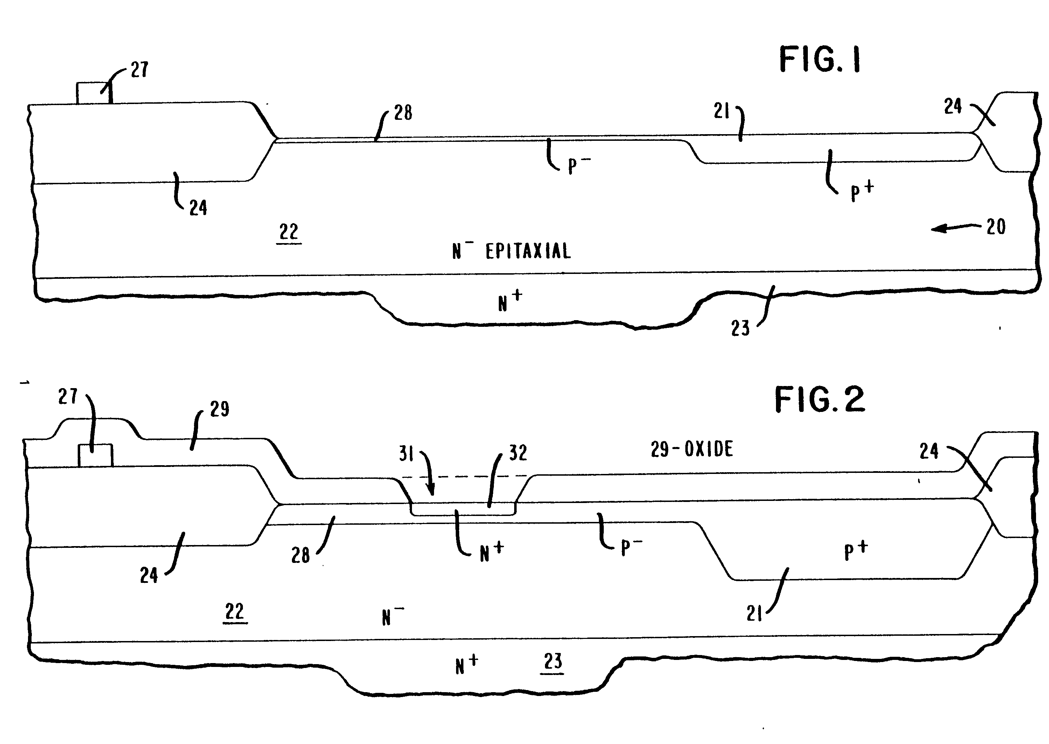

Referring now to Fig. 1, there is shown a wafer, designated generally by the numeral 20, which includes a p+ base contact region 21 in an n-epitaxial layer 22, which has been grown on n+ bulk material 23 of the wafer. A field oxide layer 24 covering wafer 20 is disposed on top of the n-epitaxial layer 22 and in juxtaposition to the base contact region 21. A doped and patterned polysilicon interconnect electrode 27 is shown to be formed on top of the field oxide layer 24.

Although not shown in Fig. 1, the structure further includes self-aligned n+ source/drain regions for polysilicon gate NMOS devices in the CMOS structure, formed by arsenic (n+) source/drain implant, anneal and drive-in steps, the areas of the PMOS devices and the PROM memory cells being masked during the arsenic implant, in accordance with known CMOS processing techniques.

A blanket base ion implant step is then performed to provide a p- active base region 28. The wafer is then annealed (to remove implant damage) at a temperature of about 950 degrees C for about one hour. This diffuses base region 28 to a depth of about 0.5 $\mu$m. The surface of the wafer 20 is then masked to expose only the p+ base contact area, region 21, and the p+ source/drain regions of the polysilicon gate PMOS devices (not shown) included in the CMOS structure. These regions are then doped with boron in accordance with standard procedures and annealed, to produce the structure shown in Fig. 1.

As is seen in Fig. 2, a layer of oxide 29 is deposited over the entire surface of the wafer. The oxide layer is then photolithographically masked so as to expose only the area 31 of the p-active base region 28 where the emitter is to be formed. The oxide 29 is then etched in accordance with conventional practice down to the surface of active base region 28 to define the emitter contact area 31 on the active base region. Unlike other bipolar processes, areas of contact to other structures, such as the polysilicon 27 and base contact region 21, are not open at this point in the process. The emitter contact area 31 on the active base region 28 is then implanted with arsenic, using a dose of about 5 x $10^{15}$ ions/cm$^2$ at about 80 KeV. Upon annealing the wafer with approximately 920 degrees C for approximately 30 minutes, a diffused emitter 32 which is approximately 0.25 $\mu$m deep is formed in the active base region 28.

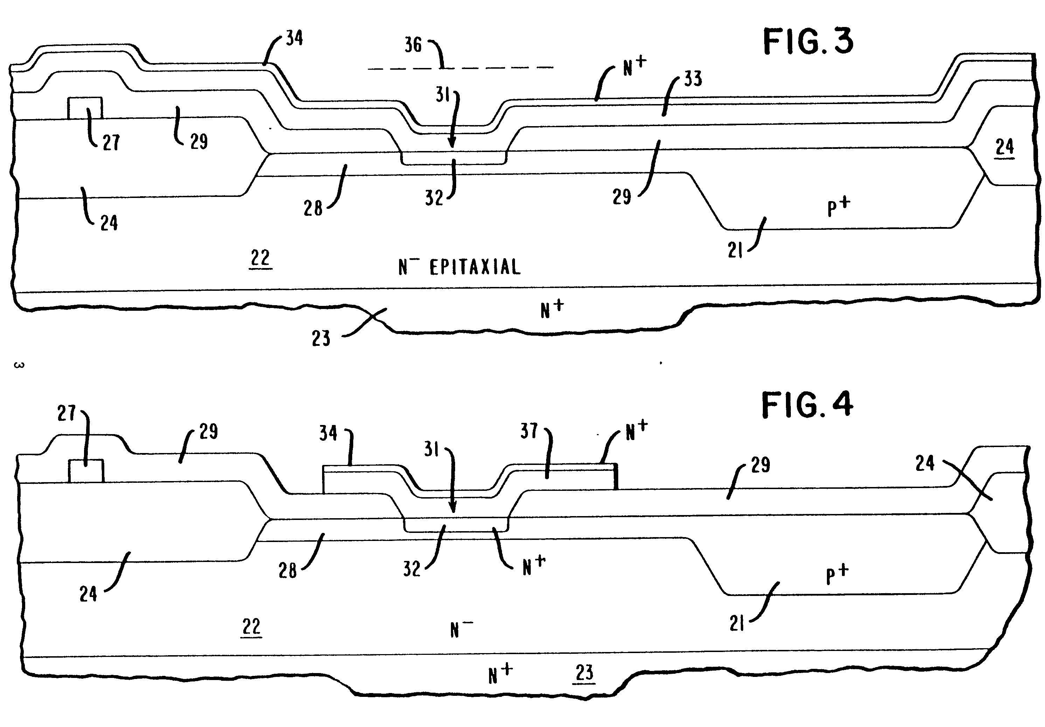

Referring now to Fig. 3, the fuse material is applied by depositing a layer of undoped polysilicon 33 to a thickness of approximately 0.5 $\mu$m over the entire surface of the wafer 20. The surface of the undoped polysilicon layer 33 is then implant-doped with arsenic, using a dose of about $10^{15}$ ions/cm$^2$ at about 40 KeV to form an n+ conductive layer 34 approximately 0.25 $\mu$m thick. An area 36 over the emitter contact area 31 is then photolithographically masked, and the exposed portion of the polysilicon layer is etched away to leave a pad 37 of polysilicon, as is seen in Fig. 4.

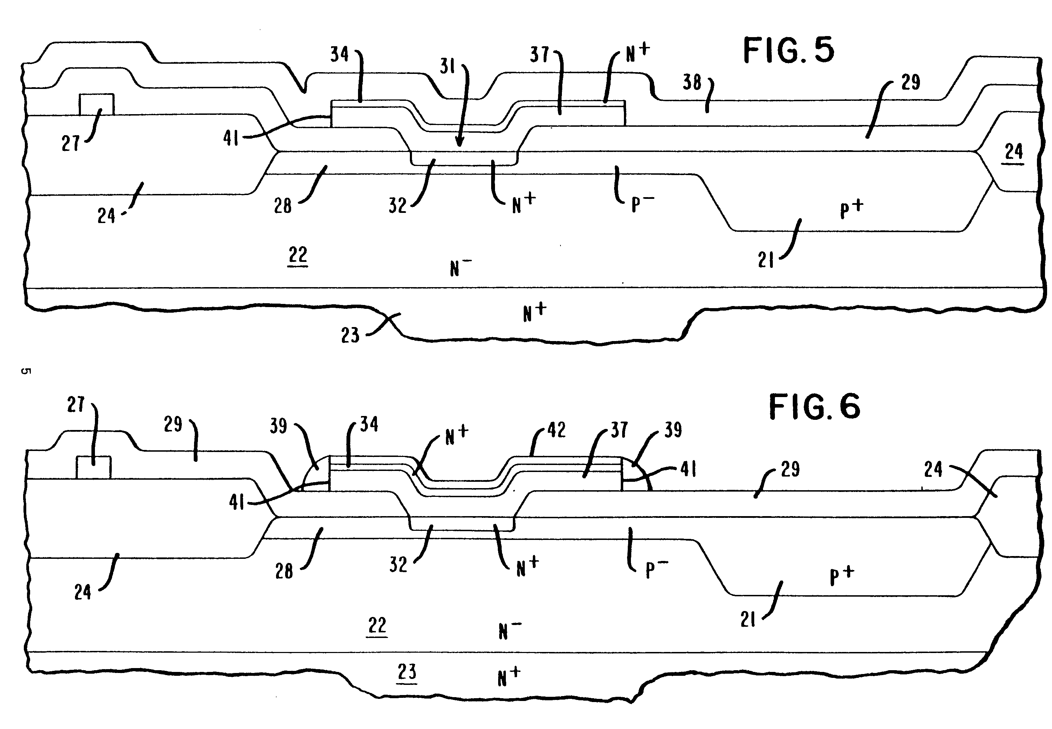

As is seen in Fig. 5, approximately 0.5 $\mu$m of silicon dioxide 38 may then be deposited uniformly over the entire wafer 20 in order to protect the edges of pad 37. The layer of silicon dioxide 38 is then etched away utilizing an anisotropic dry plasma etch applied normally with respect to the wafer 20, which leaves a deposit of oxide 39 in abutment with the peripheral edge 41 of the pad 37 (see Fig. 6). This phenomenon results because the oxide layer 38 in the region adjacent to the edge of pad 37 is twice as thick as the oxide elsewhere. Since the oxide is not laterally etched, the deposit 39 remains after the etch. This sidewall oxide is not essential to the invention but may be a desirable process step for improved device integrity and yield.

The wafer 20 is then annealed at a low temperature for a short period of time in an oxidizing ambient in order to grow approximately 10 nm (100 Angstroms) of oxide on the doped poly 34 to form a contact barrier oxide layer 42 (see Fig. 6). This short low temperature anneal forms the oxide layer 42 without causing excessive diffusion of arsenic from layer 34 into the adjacent layer 37. An appropriate anneal may be for two hours at 750 degrees C, with the first several minutes being performed in an oxidizing atmosphere.

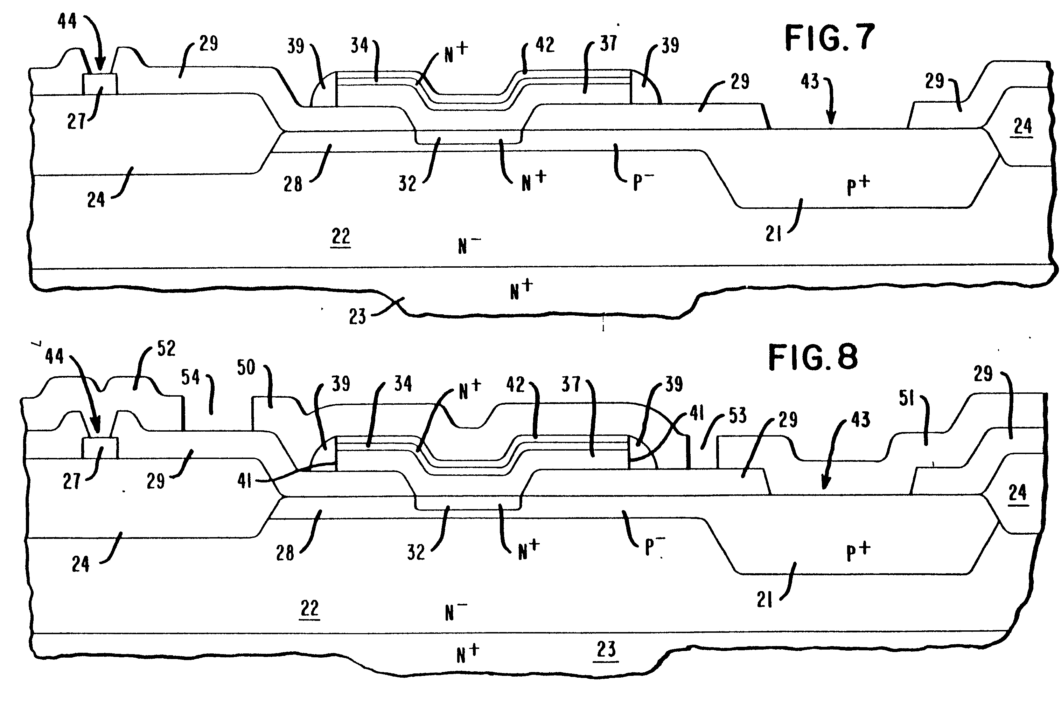

Referring now to Fig. 7, subsequent to the annealing step, standard CMOS processing is used to penetrate the oxide layer 29 and open contact areas 43 and 44 to the base contact region 21 and polysilicon interconnect 27, respectively. Contacts are also opened to CMOS device p+ and n+ diffused regions not shown in this figure.

Referring to Fig. 8, electrical connections 50, 51 and 52 are made with the fuse pad 37, base contact region 21 and polysilicon interconnect 27, respectively, by depositing a layer of metal over the wafer 20 and etching unwanted metal away from areas 53 and 54 to separate the desired connections using standard photolithographic techniques. The thin oxide barrier layer 42 between the contact 50 and the polysilicon fuse pad 37 stabilizes the low temperature annealed fuse to minimize any metal dissolution reaction during alloying of the contacts 51 and 52.

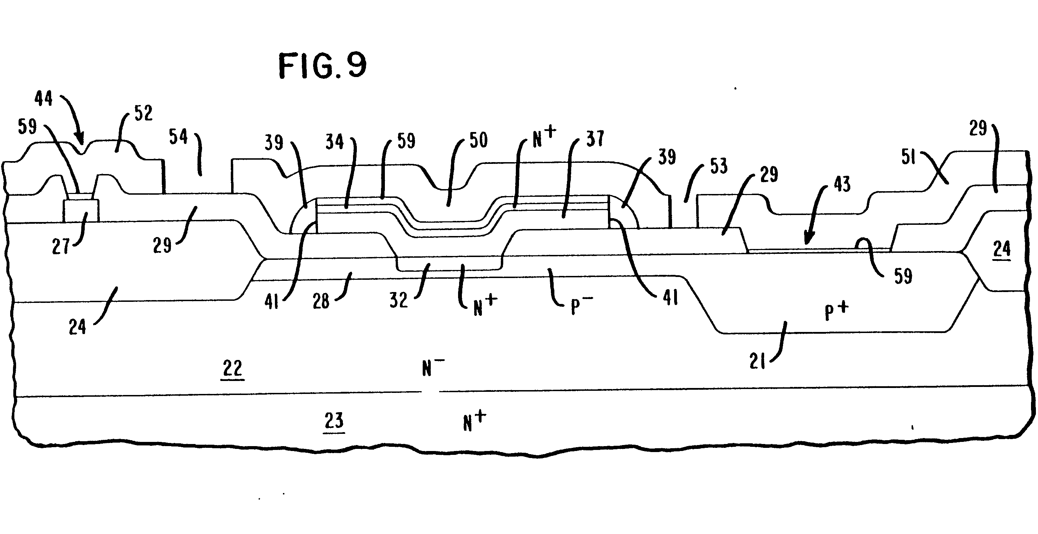

Referring now to Fig. 9, in accordance with another embodiment of the invention, after the step of Fig. 7, oxide layer 42 is removed and a layer 59 of tungsten is deposited selectively on the fuse pad 37 (with or without the sidewall oxide 39) and on the contact surfaces 43 and 44 of the base 21 and interconnect 27, respectively. The 25 nm to 100 nm (250 to 1000 Angstroms) thick tungsten layer 59 provides a contact barrier layer for subsequent metallization using 50, 51 and 52.

After the wafer 20 is completed, a passivation layer is deposited. However, openings in the passivation layer over vertical anti-fuse areas are not required, (as in devices with lateral polysilicon fuses), since during programming of this PROM no material is expelled from the fuse pads 37.

The aforedescribed process provides a merged, vertical fuse/bipolar transistor in conjunction with CMOS devices. The undoped polysilicon layer 37 functions as an "anti-fuse" which is stacked on the emitter 32 of a common collector NPN bipolar transistor to form a unique, high density, electrically programmable single transistor memory cell. The vertical, stacked configuration of the memory cell is provided while still obtaining the cost effectiveness and power advantages, of CMOS peripheral circuitry.

With reference to the embodiment in Fig. 8 of the drawings, the anti-fuse is programmed by forming a conductive path between metal interconnect 50 and diffused emitter 32 through the application of appropriate voltages to the NPN bipolar transistor. For example, the nominal resistance of several megohms between diffused emitter 32 and interconnect 50 can be reduced to the range of several thousand ohms by applying a current of one to three milliamps for a period of one to two microseconds. These programming conditions are imposed on, the device in Fig. 8 by connecting a nominal 13 volt bias to collector region 22, grounding interconnect metal 50 and applying a nominal 13 volts to diffused base 21 by way of metal 51. To constrain the magnitude of the current through the NPN transistor, the base current is limited to approximately 100 microamps.

Though the exact mechanism by which the conductive path is formed between diffused emitter 32 and metal 50 is not fully understood, it is known that the polysilicon layer 37 undergoes two changes.

First, the grain structure of the polysilicon in the region above diffused emitter 32 is reformed during programming to one of larger individual grains. Secondly, n-type dopant diffuses from emitter region 32 and doped polysilicon 34 to form a conductive path through formerly undoped polysilicon 37. The silicon dioxide of interfacial barrier oxide layer 42 has minimal effect on the programming of the anti-fuse because of its low dielectric integrity and the asperities on the upper surface of polycrystalline silicon 34. Note that in the alternate embodiment, depicted in Fig. 9, that the interfacial barrier oxide layer 42 is completely omitted.

## Claims

1. An electrically programmable read-only memory cell, including a semiconductor substrate (22, 23) having a first conductivity type, a base region (28) and a base contact region (21) having a second conductivity type provided in said substrate (22, 23), an emitter region (32) having said first conductivity type provided in said base region (28), a dielectric layer (29) provided over said base region (28) and said base contact region (21) and having openings formed therethrough, an anti-fuse structure including a region of undoped polysilicon (37) in direct contact with said emitter region (32) and a conductive layer (34) of said first conductivity type formed on said region of undoped polysilicon (37), said antifuse structure having a defined periphery extending over a portion of said dielectric layer (29), and conductive connections (50, 51) provided for said conductive layer (34) and said base contact region (21).

2. A memory cell according to claim 1, characterized by a protective oxide region (39) disposed around and in contact with the periphery of said anti-fuse structure (37, 34).

3. A memory cell according to claim 2, characterized in that an interfacial barrier oxide layer (42) is provided on said conductive layer (34).

4. A memory cell according to claim 2, characterized in that a layer of tungsten (59) is provided on said conductive layer (34).

5. A memory cell according to claim 1, characterized in that said anti-fuse structure has a thickness of approximately 0.5 µm.

6. A process of fabricating an electrically programmable read-only memory cell, including the steps of: providing a semiconductor wafer (20); forming in a base region (28) of said semiconductor wafer (20) an exposed emitter region (32) of a first conductivity type and an associated adjacent base contact region (21) for a bipolar transistor, said base and base contact regions (28, 21) having a second conductivity type; providing a region of undoped polysilicon (37) on said emitter region (32); forming a conductive layer (34) having said first conductivity type on said region of undoped polysilicon (37); and providing an ohmic connection (50) to said conductive layer (34), thereby forming a programmable anti-fuse structure (37, 34) directly, connected to the emitter region (32) of said bipolar transistor.

7. A process according to claim 6, characterized in that semiconductor wafer (20) includes an epitaxial layer of said first conductivity type embodying a collector region (22) for said bipolar transistor, and by the steps of forming in said epitaxial layer a base region (28) of said second conductivity type and forming said emitter region (32) in said base region (28) whereby a portion of said base region forms a base for said bipolar transistor.

8. A process according to claim 7, characterized in that said emitter region (32) is formed in said wafer (20) containing said base region (28) and said base contact region (21) by forming a layer of oxide (29) over said wafer (20), masking the oxide layer (29) except in an area over an emitter region (31), etching the oxide layer (29) to expose an emitter area in said base region (28), doping said emitter area with impurities of said first conductivity type, and annealing said wafer (20) to form said emitter region (32).

9. A process according to claim 8, characterized in that said anti-fuse structure (37, 34) is formed by depositing a layer of undoped polysilicon (33) over said emitter region (32) and said oxide layer (29), doping the exposed surface of the polysilicon layer (33) to form said conductive layer (34) in said polysilicon layer (33), masking the polysilicon layer (33) in an area (36) overlying and adjacent to the emitter region (32) and etching away the unmasked areas of said polysilicon layer (33) to leave said anti-fuse structure (37, 34) overlying said emitter region (32) and having a periphery overlying said oxide layer (29).

10. A process according to claim 9, characterized by the step of forming a layer of silicon dioxide (38) over said wafer (20) including said anti-fuse structure (37, 34) and etching away the layer of silicon dioxide (38) to leave a protective deposit of silicon dioxide (39) in abutment with the periphery of said antifuse structure (37, 34).

11. A process according to claim 10, characterized by the step of providing, in said layer of silicon dioxide (38) a contact area (43) for said base contact region (21), and providing metal contacts (50, 51) overlying said anti-fuse structure (37, 34) and said base contact region (21).

**Patentansprüche**

1. Elektrisch programmierbare Nurlesenspeicherzelle, mit einem Halbleitersubstrat (22, 23) eines ersten Leitfähigkeitstyps, einem Basisbereich (28) und einem Basiskontaktbereich (21) eines zweiten Leitfähigkeitstyps die in dem Substrat (22, 23) ausgebildet sind, einem Emitterbereich (32) des ersten Leitfähigkeitstyps in dem Basisbereich (28), einer dielektrischen Schicht (29) über dem Basisbereich (28) und dem Basiskontaktbereich (21), die Öffnungen durch sie hindurch ausgebildet besitzt, einer Antisicherungsstruktur mit einem Bereich aus undotiertem Polysilizium (37) in unmittelbarem Kontakt mit dem Emitterbereich (32) und einer leitenden Schicht (34) vom ersten Leitfähigkeitstyp, die auf dem Bereich aus undotierem Polysilizium (37) ausgebildet ist, wobei die Antisicherungsstruktur eine definierte Peripherie besitzt, die sich über einen Teil der dielektrischen Schicht (29) erstreckt, und leitenden Verbindungen (50, 51), die für die leitende Schicht (34) und den Basiskontaktbereich (21) vorgesehen sind.

2. Speicherzelle nach Anspruch 1, gekennzeichnet durch einen schützenden Oxidbereich (39), der um und in Kontakt mit der Peripherie der Antisicherungsstruktur (37, 34) ist.

3. Speicherzelle nach Anspruch 2, dadurch gekennzeichnet, daß eine Oxidschicht (42) als Zwischenschichtbarriere auf der leitenden Schicht (34) angeordnet ist.

4. Speicherzelle nach Anspruch 2, dadurch gekennzeichnet, daß eine Wolframschicht (59) auf der leitenden Schicht (34) angeordnet ist.

5. Speicherzelle nach Anspruch 1, dadurch gekennzeichnet, daß die Antisicherungsstruktur eine Dicke von 0,5 µm besitzt.

6. Verfahren zum Herstellen einer elektrisch programmierbaren Nurlesenspeicherzelle, mit den Schritten:

Anordnen eines Halbleiterplättchens (20');
Bilden eines freiliegenden Emitterbereichs (32)
eines ersten Leitfähigkeitstyps und eines
zugeordneten, benachbarten
Basiskontaktbereichs (21) für einen bipolaren
Transistor in einem Basisbereich (28) des
Halbleiterplättchens (20), wobei die Basis- und
Basiskontakt-Bereiche einen zweiten
Leitungsfähigkeitstyp besitzen; Vorsehen eines
Bereichs von undotiertem Polysilizium (37) auf
dem Emitterbereich (32); Bilden einer leitenden
Schicht (34) eines ersten Leitfähigkeitstyps auf
dem Bereich von undotiertem Polysilizium (37);
und Vorsehen einer Ohm'schen Verbindung (50)
mit der leitenden Schicht (34), wodurch eine
programmierbare Antisicherungsstruktur (37, 34)
gebildet wird, die mit dem Emitterbereich (32)
des bipolaren Transistors verbunden ist.

7. Verfahren nach Anspruch 6,
dadurch gekennzeichnet,
daß das Halbleiterplättchen (20) eine epitaxiale
Schicht vom ersten Leitfähigkeitstyp aufweist mit
einem Kollektorbereich (22) für den bipolaren
Transistor und durch die Schritte: Bilden eines
Basisbereichs (28) des zweiten Leitfähigkeitstyps
in der epitaxialen Schicht und Bilden des
Emitterbereichs (32) in dem Basisbereich (28),
wodurch ein Teil des Basisbereichs eine Basis für
den bipolaren Transistor bildet.

8. Verfahren nach Anspruch 7,
dadurch gekennzeichnet,
daß der Emitterbereich (32) in dem den
Basisbereich (28) und den Basiskontaktbereich
(21) enthaltenden Plättchen (20) durch Bilden
einer Oxidschicht (29) über dem Plättchen (20)
maskierender Oxidschicht (29) mit Ausnahme
einer Fläche über einem Emitterbereich (31),
Ätzen der Oxidschicht (29), um eine Emitterfläche
in dem Basisbereich (28) freizulegen, Dotieren
der Emitterfläche mit Verunreinigungen des
ersten Leitfähigkeitstyps und Wärmebehandeln
des Plättchens (20) zur Bildung des
Emitterbereichs (32) gebildet wird.

9. Verfahren nach Anspruch 8,
dadurch gekennzeichnet,
daß die Antisicherungsstruktur (37, 34) durch
Ablagern einer Schicht von undotiertem
Polysilizium (33) über dem Emitterbereich (32)
und der Oxidschicht (29), Dotieren der
freiliegenden Oberfläche der Polysiliziumschicht
(33) zur Bildung der leitenden Schicht (34) in der
Polysiliziumschicht (33), Maskieren der
Polysiliziumschicht (33) in einem Bereich (36), der
über dem und benachbart zum Emitterbereich
(32) liegt, und Wegätzen der unmaskierten
Bereiche der Polysiliziumschicht (33) gebildet
wird, wodurch die Antisicherungsstruktur (37, 34)
über dem Emitterbereich (32) belassen wird und
eine Peripherie besitzt, die über der Oxidschicht
(29) liegt.

10. Verfahren nach Anspruch 9,
gekennzeichnet durch den Schritt:
Bilden einer Schicht von Siliziumdioxid (38)
über dem die Antisicherungsstruktur (37, 34)
aufweisenden Plättchen (20) und Wegätzen der Schicht von Siliziumdioxid (38), um eine
schützende Ablagerung von Siliziumdioxid (39) in
Angrenzung zu der Peripherie der
Antisicherungsstruktur (37, 34) zu belassen.

11. Verfahren nach Anspruch 10,
gekennzeichnet durch den Schritt:
Vorsehen eines Kontaktbereichs (43) für den
Basiskontaktbereich (21) in der Schicht aus
Siliziumdioxid (38) und Vorsehen von
Metallkontakten (50, 51), die über der
Antisicherungsstruktur (37, 34) und dem
Basiskontaktbereich (21) liegen.


**Revendications**

1. Cellule de mémoire morte programmable
électriquement, comprenant un substrat semiconducteur (22, 23) ayant un premier type de
conductivité, une région de base (28) et une
région (21) de contact de base ayant un second
type de conductivité, prévues dans ledit substrat
(22, 23), une région d'émetteur (32) ayant ledit
premier type de conductivité, prévue dans ladite
région de base (28), une couche diélectrique (29)
prévue sur ladite région de base (28) et ladite
région de contact de base (21) et à travers
laquelle des ouvertures sont formées, une
structure anti-fusible comprenant une région de
silicium polycristallin non dopé (37) en contact
direct avec ladite région d'émetteur (32) et une
couche conductrice (34) dudit premier type de
conductivité formée sur ladite région de silicium
polycristallin non dopé (37), ladite structure anti-
fusible ayant une périphérie définie s'étendant
sur une partie de ladite couche diélectrique (29),
et des connexions conductrices (50, 51) prévues
pour ladite couche conductrice (34) et ladite
région de contact de base (21).

2. Cellule de mémoire selon la revendication 1,
caractérisée par une région d'oxyde de
protection (39) disposée autour de et en contact
avec la périphérie de ladite structure anti-fusible
(37, 34).

3. Cellule de mémoire selon la revendication 2,
caractérisée en ce qu'une couche d'oxyde (42)
d'arrêt d'interface est prévue sur ladite couche
conductrice (34).

4. Cellule de mémoire selon la revendication 2,
caractérisée en ce qu'une couche de tungstène
(59) est prévue sur ladite couche conductrice (34).

5. Cellule de mémoire selon la revendication 1,
caractérisée en ce que ladite structure anti-
fusible présente une épaisseur d'environ 0,5 μm.

6. Procédé de fabrication d'une cellule de
mémoire morte programmable électriquement,
comprenant les étapes qui consistent: à utiliser
une tranche semi-conductrice (20); à former dans
une région de base (28) de ladite tranche semi-
conductrice (20) une région d'émetteur exposée
(32) d'un premier type de conductivité et une
région de contact de base adjacente et associée
(21) pour un transistor bipolaire, lesdites régions
de base et de contact de base (28, 21) ayant un second type de conductivité; à prévoir une région de silicium polycristallin non dopé (37) sur ladite région d'émetteur (32); à former une couche conductrice (34) ayant ledit premier type de conductivité sur ladite région de silicium polycristallin non dopé (37); et à établir une connexion ohmique (50) sur ladite couche conductrice (34), afin de former une structure anti-fusible programmable (37, 34) connectée directement à la région d'émetteur (32) dudit transistor bipolaire.

7. Procédé selon la revendication 6, caractérisé en ce que ladite tranche semi-conductrice (20) comprend une couche épitaxiale dudit premier type de conductivité renfermant une région de collecteur (22) pour ledit transistor bipolaire, et par les étapes qui consistent à former dans ladite couche épitaxiale une région de base (28) dudit second type de conductivité et à former ladite région d'émetteur (32) dans ladite région de base (28) de manière qu'une partie de ladite région de base forme une base pour ledit transistor bipolaire.

8. Procédé selon la revendication 7, caractérisé en ce que ladite région d'émetteur (32) est formée dans ladite tranche (20) contenant ladite région de base (28) et ladite région de contact de base (21) par formation d'une couche d'oxyde (29) sur ladite tranche (20), masquage de la couche d'oxyde (29) à l'exception d'une zone au-dessus d'une région d'émetteur (31), attaque de la couche d'oxyde (29) pour mettre à découvert une zone d'émetteur dans ladite région de base (28), dopage de ladite zone d'émetteur avec des impuretés dudit premier type de conductivité, et recuit de ladite tranche (20) pour former ladite région d'émetteur (32).

9. Procédé selon la revendication 8, caractérisé en ce que ladite structure anti-fusible (37, 34) est formée par le dépôt d'une couche de silicium polycristallin non dopé (33) sur ladite région d'émetteur (32) et ladite couche d'oxyde (29), le dopage de la surface exposée de la couche de silicium polycristallin (33) pour former ladite couche conductrice (34) dans ladite couche (33) de silicium polycristallin, masquage de la couche (33) de silicium polycristallin dans une zone (36) recouvrant la région d'émetteur (32) et adjacente à celle-ci, et l'élimination par attaque des zones non masquées de ladite couche (33) de silicium polycristallin pour laisser ladite structure anti-fusible (37, 34) recouvrant ladite région d'émetteur (32) et ayant une périphérie recouvrant ladite couche d'oxyde (29).

10. Procédé selon la revendication 9, caractérisé par l'étape consistant à former une couche de dioxyde de silicium (38) sur ladite tranche (20) comprenant ladite structure anti-fusible (37, 34) et à éliminer par attaque la couche de dioxyde de silicium (38) pour laisser un dépôt protecteur de dioxyde de silicium (39) en butée avec la periphérie de ladite structure anti-fusible (37, 34).

11. Procédé selon la revendication 10, caractérisé par l'étape consistant à établir, dans ladite couche de dioxyde de silicium (38), une zone de contact (43) pour ladite région de contact de base (21), et à établir des contacts métalliques (50, 51) recouvrant ladite structure anti-fusible (37, 34) et ladite région de contact de base (21).

## FIG.1

27

28

21

24

24

22

$P^-$

$P^+$

20

$N^-$ EPITAXIAL

$N^+$

23

EP 0 172 193 B1

## FIG.2

27

29

31

32

29 - OXIDE

24

28

$N^+$

$P^-$

24

21

22

$N^-$

$P^+$

21

$N^+$

23

FIG.3

FIG.4

N⁻ EPITAXIAL

P⁺

N⁺

N⁻

N⁺

22

23

## FIG.5

## FIG.6

EP 0 172 193 B1

**FIG.7**

**FIG.8**

FIG.9